# EUROPEAN PATENT SPECIFICATION

(11) **EP 3 503 176 B1**
(45) Date of publication and mention of the grant of the patent: **20.01.2021**
(21) Application number: 17844829.6
(22) Date of filing: 22.02.2017
(51) Int. Cl.: H01L 23/31, H01L 23/42, H01L 23/373, H01L 23/367

(54) **SEMICONDUCTOR APPARATUS AND MANUFACTURING METHOD**
HALBLEITERVORRICHTUNG UND HERSTELLUNGSVERFAHREN
APPAREIL SEMI-CONDUCTEUR ET PROCÉDÉ DE FABRICATION

(30) Priority: 31.08.2016 CN 201610799678
(43) Date of publication of application: 26.06.2019
(73) Proprietor: Huawei Technologies Co., Ltd., Longgang District Shenzhen, Guangdong 518129 (CN)
(72) Inventor: LIN, Zhirong, Shenzhen Guangdong 518129 (CN); HUANG, Wenjun, Shenzhen Guangdong 518129 (CN)
(74) Representative: Gill Jennings & Every LLP
(86) International application number: PCT/CN2017/074449
(87) International publication number: WO 2018/040519

(56) References cited:
- CN-A- 1 885 850
- CN-A- 1 917 200
- CN-A- 105 355 610
- CN-A- 106 356 341
- US-A1- 2008 073 776
- US-A1- 2009 294 938
- US-A1- 2012 119 346
- US-A1- 2014 131 856

## Description

### TECHNICAL FIELD

The present invention relates to the field of semiconductor technologies, and in particular, to a semiconductor apparatus and a manufacturing method thereof.

### BACKGROUND

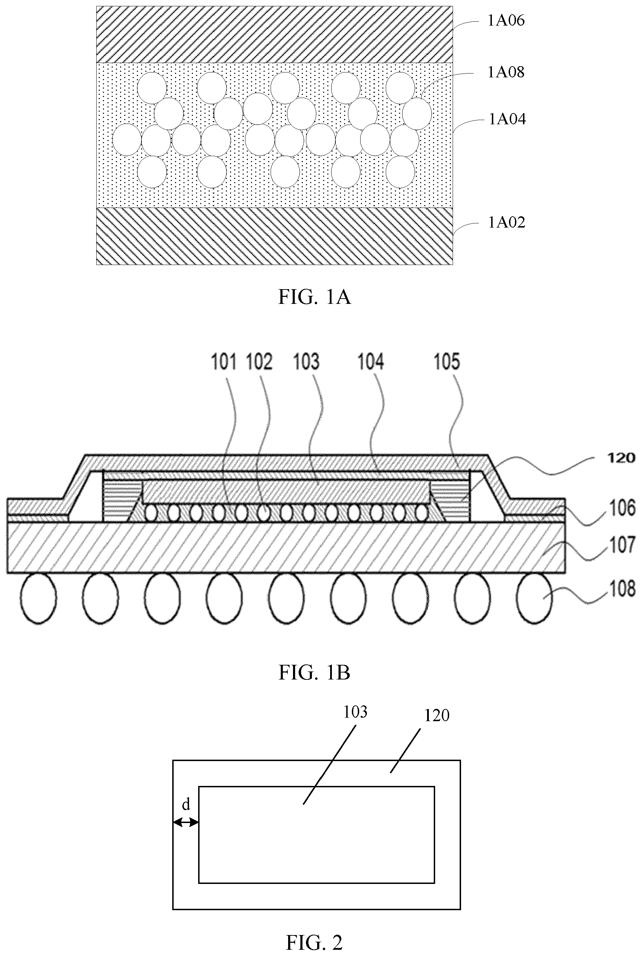

FIG. 1A is a schematic sectional view of an integrated circuit chip in the prior art and a partial package structure of the integrated circuit chip. The structure includes an integrated circuit chip 1A02, a thermal interface material layer 1A04, and a heat sink 1A06. The thermal interface material layer 1A04 has multiple metal particles 1A08 distributed in a form of a dispersed phase. Heat generated by the integrated circuit chip 1A02 in an operating process is guided into the heat sink 1A06 through the thermal interface material layer 1A04 on a rear side of the chip. However, in the prior art, because a size of the integrated circuit chip 1A02 is limited, a heat transfer effect is relatively undesirable. Consequently, it is very difficult to meet a heat dissipation requirement of a high-power chip.

A US patent application, numbered as US20090294938, provides a filp-chip package with fan-out WLCSP.

A US patent application, numbered as US20140131856, provides a semiconductor device and manufacture method thereof.

A US patent application, numbered as US20120119346, provides a semiconductor package and method of forming the same.

A Chinese patent application, numbered as CN105355610, provides a circuit device and manufacture method thereof.

A US patent application, numbered as US20080073776, provides a sintered metallic thermal interface materials for microelectronic cooling assembles.

### SUMMARY

Embodiments of the present invention provide a semiconductor apparatus and a manufacturing method thereof. In the semiconductor apparatus, a contact area between a thermal interface material layer and a circuit device is increased by using a disposed packaging layer, so as to greatly improve thermal conductivity effectiveness of an entire heat conduction path, thereby better meeting a heat dissipation requirement of a high-power-consumption circuit device.

According to a first aspect, an embodiment of the present invention provides a semiconductor apparatus, including a circuit device and a heat sink fin that are disposed in a laminated manner, and a thermal interface material layer located between the circuit device and the heat sink fin, where
a packaging layer is disposed around a side wall of the circuit device, the circuit device includes an integrated circuit die, the integrated circuit die is provided with a pin, one surface that is of the integrated circuit die and on which the pin is disposed is a mounting surface, and the side wall of the circuit device is a wall that is of the integrated circuit die and that is adjacent to the mounting surface; and
the thermal interface material layer has a first surface facing the circuit device and the packaging layer and a second surface facing the heat sink fin, the first surface is thermally coupled to the circuit device and the packaging layer, and the second surface is thermally coupled to the heat sink fin,
the semiconductor device further comprises a substrate, the integrated circuit die is coupled to the substrate by using a metal bump, the metal bump is protected by bottom filler, the packaging layer envelops the side wall of the integrated circuit die and a side wall of the bottom filler,
the heat sink fin is fastened on the substrate by using an adhesive.

In the foregoing solution, because the packaging layer is disposed around the circuit device, and the packaging layer and the circuit device are both thermally coupled to the thermal interface material layer, a contact area between the circuit device and the thermal interface material layer is increased. In addition, heat generated on the side wall of the circuit device may be transferred to the thermal interface material layer through the packaging layer, and then transferred to the heat sink fin, thereby improving a heat dissipation effect of the semiconductor apparatus. In addition, one packaging layer is disposed around an exterior side of the circuit device, so as to increase a laying area of the thermal interface material layer, increase an area of a contact surface of the thermal interface material layer, reduce an interface stress, and correspondingly improve component reliability.

The packaging layer uses a plastic film layer. The plastic film layer has a desirable heat transfer effect, and can rapidly transfer the heat generated on the side wall of the circuit device to the thermal interface material layer, thereby improving heat dissipation efficiency of the circuit device.

The thermal interface material layer includes: a first alloy layer, thermally coupled to the circuit device and the packaging layer; a nano-metal particle layer, thermally coupled to the first alloy layer, where the nano-metal particle layer includes multiple nano-metal particles that are coupled to each other and an intermediate mixture, and the intermediate mixture is filled between the multiple nano-metal particles; and a second alloy layer, thermally coupled to the nano-metal particle layer and the heat sink fin. The used thermal interface material layer no longer includes high polymer materials with a relatively low thermal conductivity in silver adhesive materials, but includes nano-metal particles instead. The thermal interface material in this embodiment of the present invention has a relatively high thermal conductivity, so as to greatly improve thermal conductivity effectiveness of an entire heat conduction path, thereby better meeting a heat dissipation requirement of a high-power chip.

In specific disposition, a sintered continuous phase structure is formed at a contact portion between the first alloy layer and the nano-metal particle layer, sintered continuous phase structure is formed at a contact portion between the second alloy layer and the nano-metal particle layer. A connection effect between the circuit device and the heat sink fin is improved by using the sintered continuous phase structure, and a heat transfer effect between the circuit device and the heat sink fin is improved.

In a specific implementation solution, the nano-metal particles include silver, and have a desirable heat transfer effect. In addition, in specific disposition, diameters of the nano-metal particles are between 50 nanometers and 200 nanometers.

The semiconductor apparatus provided in this embodiment is used for a flip chip ball grid array package structure.

The first alloy layer includes a first adhesive layer and a first co-sintered layer, the first adhesive layer is thermally coupled to the circuit device and the packaging layer, the first co-sintered layer is coupled to the nano-metal particle layer, and a sintered continuous phase structure is formed at a contact portion between the first co-sintered layer and the nano-metal particle layer. By using the foregoing structure, connection strength of thermal coupling of the first alloy layer to the circuit device and the packaging layer is increased, and a desirable heat transfer effect is achieved.

In specific disposition, the first adhesive layer includes any one of the following materials: titanium, chromium, nickel, or a nickel-vanadium alloy, and the first co-sintered layer includes any one of the following materials: silver, gold, or copper. The foregoing materials all have relatively desirable heat transfer effects.

In addition, in a solution, the first alloy layer further includes a first buffer layer, located between the first adhesive layer and the first co-sintered layer, and the first buffer layer includes any one of the following materials: aluminum, copper, nickel, or a nickel-vanadium alloy.

In specific disposition, the second alloy layer includes a second adhesive layer and a second co-sintered layer, the second adhesive layer is thermally coupled to the heat sink fin, the second co-sintered layer is thermally coupled to the nano-metal particle layer, and a sintered continuous phase structure is formed at a contact portion between the second co-sintered layer and the nano-metal particle layer. By using the foregoing structure, connection strength of thermal coupling of the second alloy layer to the heat sink fin is increased, and a desirable heat transfer effect is achieved.

In addition, in specific disposition, the second adhesive layer includes any one of the following materials: titanium, chromium, nickel, or a nickel-vanadium alloy, and the second co-sintered layer includes any one of the following materials: silver, gold, or copper. The foregoing materials all have relatively desirable heat transfer effects.

In a solution, the second alloy layer further includes a second buffer layer, located between the second adhesive layer and the second co-sintered layer, and the second buffer layer includes any one of the following materials: aluminum, copper, nickel, or a nickel-vanadium alloy.

Diameters of the nano-metal particles are not greater than 1 micrometer.

Different materials may be selected for the intermediate mixture. In a specific implementation, the intermediate mixture includes either of the following materials: air or resin.

An embodiment of the present invention provides a semiconductor apparatus manufacturing method, including: disposing a packaging layer around a side wall of a circuit device, where the circuit device includes an integrated circuit die, the integrated circuit die is provided with a pin, one surface that is of the integrated circuit die and on which the pin is disposed is a mounting surface, and the side wall of the circuit device is a wall that is of the integrated circuit die and that is adjacent to the mounting surface;
generating a thermal interface material layer, where the thermal interface material layer has a first surface facing the circuit device and the packaging layer and a second surface facing the heat sink fin; and
thermally coupling the first surface to the circuit device and the packaging layer, and thermally coupling the second surface to the heat sink fin.

In the foregoing solution, because the packaging layer is disposed around the circuit device, and the packaging layer and the circuit device are both thermally coupled to the thermal interface material layer, a contact area between the circuit device and the thermal interface material layer is increased. In addition, heat generated on the side wall of the circuit device may be transferred to the thermal interface material layer through the packaging layer, and then transferred to the heat sink fin, thereby improving a heat dissipation effect of the semiconductor apparatus. In addition, one packaging layer is disposed around an exterior side of the circuit device, so as to increase a laying area of the thermal interface material layer, increase an area of a contact surface of the thermal interface material layer, reduce an interface stress, and correspondingly improve component reliability.

During specific fabrication, the generating a thermal interface material layer, where the thermal interface material layer has a first surface facing the circuit device and the packaging layer and a second surface facing the heat sink fin is specifically:
generating a first alloy layer;
generating a nano-metal particle layer by using multiple nano-metal particles that are coupled to each other and an intermediate mixture, and filling the intermediate mixture between the multiple nano-metal particles;
generating a second alloy layer; and
thermally coupling the nano-metal particle layer to the first alloy layer and the second alloy layer separately, where one surface that is of the first alloy layer and that deviates from the nano-metal particle layer is the first surface, and one surface that is of the second alloy layer and that deviates from the nano-metal particle layer is the second surface.

The manufacturing method further includes: forming a sintered continuous phase structure at a contact portion between the first alloy layer and the nano-metal particle layer, forming sintered continuous phase structures at contact portions between the nano-metal particles, and forming a sintered continuous phase structure at a contact portion between the second alloy layer and the nano-metal particle layer.

Diameters of the nano-metal particles are not greater than 1 micrometer.

The intermediate mixture includes either of the following materials: air or resin.

During specific fabrication of the first alloy layer, a first adhesive layer and a first co-sintered layer are generated, the first adhesive layer is thermally coupled to the circuit device and the packaging layer, the first co-sintered layer is coupled to the nano-metal particle layer, and a sintered continuous phase structure is formed at a contact portion between the first co-sintered layer and the nano-metal particle layer.

During specific fabrication of the second alloy layer, a second adhesive layer and a second co-sintered layer are generated, the second adhesive layer is thermally coupled to the heat sink fin, the second co-sintered layer is thermally coupled to the nano-metal particle layer, and a sintered continuous phase structure is formed at a contact portion between the second co-sintered layer and the nano-metal particle layer.

The disposing a packaging layer around a side wall of a circuit device includes: disposing the packaging layer around the side wall by using a plastic film as a material for manufacturing the packaging layer. The plastic film has a desirable heat transfer effect. Heat dissipation efficiency of the circuit device is improved by using the disposed packaging layer that is fabricated from the plastic film.

### BRIEF DESCRIPTION OF DRAWINGS

To describe the technical solutions in the embodiments of the present invention or in the prior art more clearly, the following briefly describes the accompanying drawings required for describing the embodiments or the prior art. Apparently, the accompanying drawings in the following description show merely some embodiments of the present invention, and a person of ordinary skill in the art may still derive other drawings from these accompanying drawings without creative efforts.
FIG. 1A is a schematic sectional view of a package structure including a semiconductor apparatus in the prior art;
FIG. 1B is a schematic sectional view of a semiconductor apparatus according to a first embodiment of the present invention;
FIG. 2 is a schematic diagram of a combination of a circuit device and a packaging layer of the semiconductor apparatus according to the first embodiment of the present invention;
FIG. 3 is a schematic sectional view of thermal coupling of a thermal interface material layer to the circuit device and the packaging layer according to the first embodiment;
FIG. 4 is a schematic sectional view of a first embodiment of a first alloy layer in FIG. 3;
FIG. 5 is a schematic sectional view of a second embodiment of the first alloy layer in FIG. 3;
FIG. 6 is a schematic sectional view of a first embodiment of a second alloy layer in FIG. 3;
FIG. 7 is a schematic sectional view of a second embodiment of the second alloy layer in FIG. 3; and
FIG. 8 is a flowchart of a semiconductor apparatus manufacturing method according to a second embodiment of the present invention.

### DESCRIPTION OF EMBODIMENTS

The following clearly and completely describes the technical solutions in the embodiments of the present invention with reference to the accompanying drawings in the embodiments of the present invention. Apparently, the described embodiments are merely some but not all of the embodiments of the present invention. All other embodiments obtained by a person of ordinary skill in the art based on the embodiments of the present invention without creative efforts shall fall within the protection scope of the present invention.

For convenience of description, a side wall of a circuit device is defined in the embodiments. In the embodiments, the side wall of the circuit device is a wall that is of the circuit device and that is adjacent to one surface (a mounting surface) on which a pin is disposed. In FIG. 1B, FIG. 1B is a schematic sectional view of a semiconductor apparatus according to a first embodiment of the present invention. Using a placement direction of the semiconductor apparatus as a reference direction, a side wall of the circuit device is one surface in a vertical direction shown in FIG. 1B.

An embodiment of the present invention provides a semiconductor apparatus. The semiconductor apparatus includes: a circuit device and a heat sink fin 105 that are disposed in a laminated manner, and a thermal interface material layer 104 located between the circuit device and the heat sink fin 105, where
a packaging layer 120 is disposed around a side wall of the circuit device, the circuit device includes an integrated circuit die 103, the integrated circuit die 103 is provided with a pin, one surface that is of the integrated circuit die 103 and on which the pin is disposed is a mounting surface, and the side wall of the circuit device is a wall that is of the integrated circuit die 103 and that is adjacent to the mounting surface; and
the thermal interface material layer 104 has a first surface facing the circuit device and the packaging layer 120 and a second surface facing the heat sink fin 105, the first surface is thermally coupled to the circuit device and the packaging layer 120, and the second surface is thermally coupled to the heat sink fin 105.

Referring to FIG. 1B and FIG. 2 together, FIG. 1B is a schematic sectional view of the semiconductor apparatus according to the first embodiment of the present invention. FIG. 2 is a top view of a combination of the circuit device and the packaging layer in this embodiment. FIG. 2 is a schematic structural diagram of the circuit device (the integrated circuit die 103) and the packaging layer 120 that are seen from top to bottom by using a placement direction of the device shown in FIG. 1B as a reference direction. In FIG. 2, the circuit device has a regular rectangular shape. It should be understood that, FIG. 2 shows only a positional relationship between the circuit device and the packaging layer 120. A shape of the circuit device is not limited to the rectangular shape in FIG. 2, and may be any other shape. With reference to FIG. 1B and FIG. 2, it may be known that, the packaging layer 120 provided in this embodiment is disposed around the side wall of the circuit device. That is, the packaging layer 120 may be considered as a structure that is formed by surrounding the circuit device and that envelops the side wall of the circuit device. That is, as shown in FIG. 1B, when the circuit device includes the integrated circuit die 103 and a bottom filler 101, the packaging layer 120 envelops a side wall of the integrated circuit die 103 and a side wall of the bottom filler 101. In addition, a top surface of the packaging layer 120 (one surface that is of the packaging layer and that can be seen in FIG. 2) is flush with a top surface of the integrated circuit die 103 (one surface that is of the integrated circuit die 103 and that can be seen in FIG. 2). The top surface of the packaging layer 120 and the top surface of the integrated circuit die 103 together form a contact surface that is connected to the thermal interface material layer 104. The heat sink fin 105 is fastened on a substrate 107 by using an adhesive 106, and the pin of the integrated circuit die 103 is connected to a circuit of the substrate 107. The thermal interface material layer 104 is thermally coupled to the integrated circuit die 103 and the heat sink fin 105. In specific disposition, the thermal interface material layer 104 covers the top surfaces (surfaces shown in FIG. 2) of the integrated circuit die 103 and the packaging layer 120, and is thermally coupled to the top surfaces. Because the packaging layer 120 has a particular thickness d (that is, a width of a frame-shaped surface), the packaging layer120 forms a frame-shaped contact surface (as shown in FIG. 2) that is thermally coupled to the thermal interface material layer 104. In addition, in specific disposition, the packaging layer 120 has the specified thickness d to ensure that the packaging layer 120 can completely package the circuit device. Therefore, a frame of the frame-shaped contact surface has a particular width (the width is equal to the thickness of the packaging layer 120). Specifically, when there is no packaging layer 120, a coupling area is only an area of the top surface of the integrated circuit die 103. After the packaging layer 120 is added, as shown in FIG. 2, the coupling area is a sum of the area of the top surface of the integrated circuit die 103 and an area of the top surface of the packaging layer 120, so that an area of a thermal coupling surface between the thermal interface material layer 104 and the integrated circuit die 103 is increased. In addition, the coupling area is increased, so that connection strength between the thermal interface material layer 104 and the integrated circuit die 103 is increased, and an interface stress is reduced (an entire stress stays unchanged, but a contact area is increased, so that stress impact on per unit of area is reduced), thereby improving component reliability performance.

In addition, in specific disposition, the packaging layer 120 is attached on the side wall of the circuit device. Therefore, during heat dissipation, heat on the side wall of the circuit device is transferred to the thermal interface material layer 104 through the packaging layer 120, and is further dissipated to the heat sink fin 105. By using the foregoing structure, it may be known that a heat dissipation manner of the circuit device is dissipating heat on a top surface of the circuit device along a path from the thermal interface material layer 104 to the heat sink fin 105 and dissipating the heat on the side wall of the circuit device along a path from the packaging layer 120 through the thermal interface material layer 104 to the heat sink fin 105, so as to increase a heat dissipation area of the circuit device, thereby improving a heat dissipation effect of the circuit device.

In a specific implementation, the packaging layer 120 uses a plastic film layer. The plastic film layer has a desirable packaging effect and a desirable heat transfer effect, so that the plastic film layer can rapidly transfer heat to the thermal interface material layer, thereby improving the heat dissipation effect of the circuit device.

As shown in FIG. 1B and FIG. 2, when a flip chip ball grid array package structure is used, the entire semiconductor apparatus includes a solder ball 108, the substrate 107, the adhesive 106, a metal bump (BUMP) 102, the circuit device (for example, the integrated circuit die 103), the packaging layer 120 (for example, the plastic film layer) disposed around the circuit device 103, the thermal interface material layer 104, and the heat sink fin 105. The integrated circuit die 103 is coupled to the substrate 107 by using the metal bump 102. The metal bump 102 is protected by the bottom filler 101, and the packaging layer 120 is disposed around the integrated circuit die 103. In addition, in specific disposition, in this embodiment, thermal coupling includes a case in which there is heat transfer between different layers, different structures, or different apparatuses. More specifically, the thermal interface material layer 104 may be located between the integrated circuit die 103 and the heat sink fin 105. In addition, a substrate in the integrated circuit die 103 is thermally coupled to the thermal interface material layer 104, and the packaging layer is also thermally coupled to the thermal interface material layer 104. Heat of the integrated circuit die 103 reaches the heat sink fin 105 through the thermal interface material layer 104.

The integrated circuit die 103, the packaging layer 120 disposed around the circuit device 103, the thermal interface material layer 104, and the heat sink fin 105 may be some or all of components of a semiconductor apparatus. The semiconductor apparatus may be used for the flip chip ball grid array package structure shown in the figure, but no limitation is set thereto.

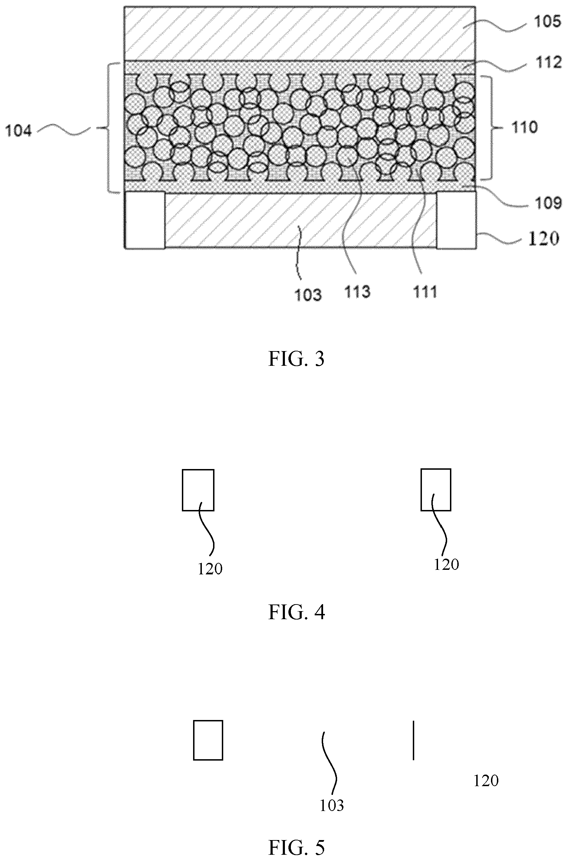

FIG. 3 is a schematic sectional view of thermal coupling of the thermal interface material layer to the circuit device and the packaging layer according to the first embodiment. FIG. 3 shows only an upper half structure of the integrated circuit die 103 that are connected to the thermal interface material layer 104 being connected in FIG. 1B. For the packaging layer 120, also only an upper half structure of the packaging layer 120 is shown. The upper half structure does not include the bottom filler 101. The thermal interface material layer 104 is thermally coupled to the integrated circuit die 103, the packaging layer 120, and the heat sink fin 105, and includes a first alloy layer 109, a nano-metal particle layer 110, and a second alloy layer 112.

The nano-metal particle layer 110 is thermally coupled to the integrated circuit die 103 and the packaging layer 120 by using the first alloy layer 109. More specifically, as shown in FIG. 3, the first alloy layer 109 may be located on the integrated circuit die 103 and the packaging layer 120 and under the nano-metal particle layer 110. That is, the first alloy layer 109 may be located between the integrated circuit die 103 and the nano-metal particle layer 110. The first alloy layer 109 increases adhesive strength between the integrated circuit die 103 and the nano-metal particle layer 110, and a coverage area of the first alloy layer 109 is increased by disposing the packaging layer 120. That is, an area of the formed first alloy layer 109 is increased, thereby increasing an area of the formed thermal interface material layer 104.

The nano-metal particle layer 110 includes nano-metal particles and an intermediate mixture. The intermediate mixture includes, but is not limited to, either of the following materials: air or resin. The intermediate mixture is filled between multiple nano-metal particles, to make the multiple nano-metal particles form a whole. The nano-metal particles include, but are not limited to, silver. Diameters of the nano-metal particles are not greater than 1 micrometer. In an embodiment, the diameters of the nano-metal particles are between 50 nanometers and 200 nanometers. The nano-metal particle layer 110 has a relatively low thermal resistance, and forms a relatively desirable heat conduction path.

The second alloy layer 112 is thermally coupled to the nano-metal particle layer 110 and the heat sink fin 105. More specifically, as shown in the figure, the second alloy layer 112 may be located on the nano-metal particle layer 110 and under the heat sink fin 105. That is, the second alloy layer 112 may be located between the nano-metal particle layer 110 and the heat sink fin 105. The second alloy layer 112 increases adhesive strength between the nano-metal particle layer 110 and the heat sink fin 105.

In an embodiment, a sintered continuous phase structure is formed at a contact portion between the first alloy layer 109 and the nano-metal particle layer 110, sintered continuous phase structures are formed at contact portions between the nano-metal particles, and a sintered continuous phase structure is formed at a contact portion between the second alloy layer 112 and the nano-metal particle layer 110. The sintered continuous phase structure in this specification includes, but is not limited to, a whole structure formed of metal particles as metal atoms near contact portions of the metal particles spread to metal particle interfaces and fuse with the metal particle interfaces because the metal particles are sintered.

FIG. 4 is a schematic sectional view of a first embodiment of the first alloy layer 109 in FIG. 3. FIG. 4 also shows only an upper half structure of the packaging layer 120 and the integrated circuit die 103. As shown in the figure, the first alloy layer 109 includes a first adhesive layer 114 and a first co-sintered layer 115. A co-sintered layer in this specification includes, but is not limited to, a metal layer that is generated in a packaging process and that fuses with a thermal interface material layer, and the metal layer and particles in the thermal interface material layer are co-sintered to form a heat flux path. The first adhesive layer 114 is thermally coupled to the integrated circuit die 103 and the packaging layer 120. The first co-sintered layer 115 is thermally coupled to the nano-metal particle layer 110. A sintered continuous phase structure is formed at a contact portion between the first co-sintered layer 115 and the nano-metal particle layer 110. Specifically, the first adhesive layer 114 may be located on the integrated circuit die 103 and the packaging layer 120, and the first co-sintered layer 115 may be located on the first adhesive layer 114 and under the nano-metal particle layer 110. The first adhesive layer 114 includes, but is not limited to, any one of the following materials: titanium, chromium, nickel, or nickel/vanadium. The first adhesive layer 114 increases bonding strength between the integrated circuit die 103 and the first co-sintered layer 115. The first co-sintered layer 115 includes, but is not limited to, any one of the following materials: silver, gold, or copper.

FIG. 5 is a schematic sectional view of a second embodiment of the first alloy layer 109 in FIG. 3. FIG. 5 also shows only an upper half structure of the packaging layer 120 and the integrated circuit die 103. Compared with FIG. 3, the first alloy layer 109 in FIG. 4 further includes a first buffer layer 116 located between the first adhesive layer 114 and the first co-sintered layer 115. The first buffer layer 116 includes, but is not limited to, any one of the following materials: aluminum, copper, or nickel. The first buffer layer 116 provides a stress buffering function during deformation caused by heat processing, and reduces a risk of a crack that appears between the integrated circuit die 103 and the thermal interface material layer 114 or in the middle of the thermal interface material layer 114, thereby increasing reliability of the semiconductor apparatus.

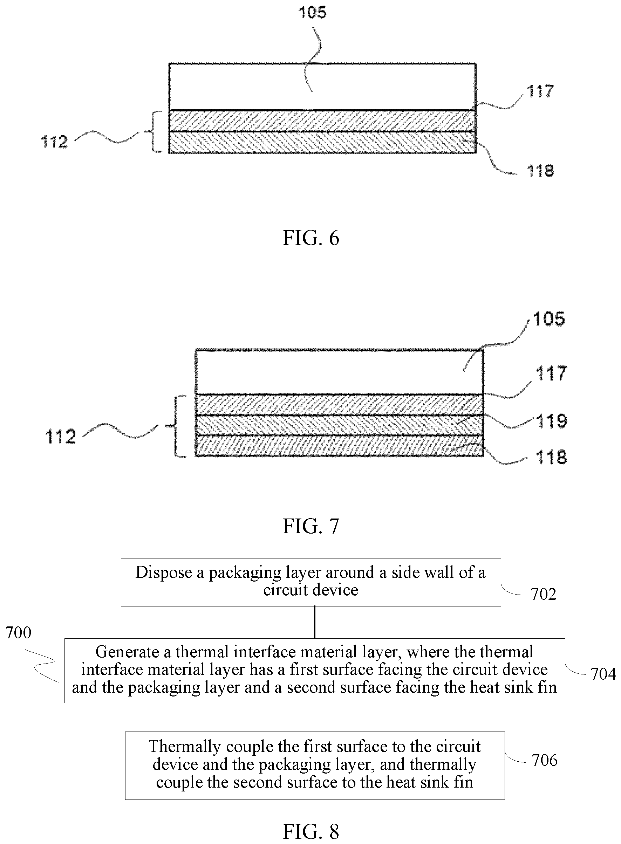

FIG. 6 is a schematic sectional view of a first embodiment of the second alloy layer 112 in FIG. 3. As shown in the figure, the second alloy layer 112 includes a second co-sintered layer 118 and a second adhesive layer 117. The second co-sintered layer 118 is thermally coupled to the nano-metal particle layer 110. A sintered continuous phase structure is formed at a contact portion between the second co-sintered layer 118 and the nano-metal particle layer 110. The second adhesive layer 117 is thermally coupled to the heat sink fin 105. Specifically, the second co-sintered layer 118 may be located on the nano-metal particle layer 110, and the second adhesive layer 117 may be located on the second co-sintered layer 118 and under the heat sink fin 105. The second co-sintered layer 118 includes, but is not limited to, any one of the following materials: silver, gold, or copper. The second adhesive layer 117 includes, but is not limited to, any one of the following materials: titanium, chromium, nickel, or nickel/vanadium. The second adhesive layer 117 increases bonding strength between the second co-sintered layer 115 and the heat sink fin 105.

FIG. 7 is a schematic sectional view of a second embodiment of the second alloy layer 112 in FIG. 3. Compared with FIG. 6, the second alloy layer 112 in FIG. 7 further includes a second buffer layer 119 located between the second adhesive layer 117 and the second co-sintered layer 118. The second buffer layer 119 includes, but is not limited to, any one of the following materials: aluminum, copper, nickel, or nickel/vanadium. The second buffer layer 119 provides a buffering function during deformation caused by heat processing, and reduces a risk of a crack that appears between the thermal interface material layer and the heat sink fin 105 or in the middle of the thermal interface material layer 114, thereby increasing reliability of the apparatus.

In conclusion, because the thermal interface material layer in this embodiment of the present invention no longer includes high polymer materials with a relatively low thermal conductivity in silver adhesive materials, but includes nano-metal particles instead. The thermal interface material in this embodiment of the present invention has a relatively high thermal conductivity, so as to greatly improve thermal conductivity effectiveness of an entire heat conduction path, thereby better meeting a heat dissipation requirement of a high-power chip. In addition, one packaging layer 120 is disposed around an exterior side of the integrated circuit die 103, so as to increase a laying area of the thermal interface material layer, increase an area of a contact surface of the thermal interface material layer, reduce an interface stress, and correspondingly improve component reliability.

FIG. 8 is a flowchart 700 of a semiconductor apparatus manufacturing method according to a second embodiment of the present invention. As shown in the figure, in step 702, a packaging layer is disposed around a side wall of a circuit device. The circuit device includes an integrated circuit die. The integrated circuit die is provided with a pin, and one surface that is of the integrated circuit die and on which the pin is disposed is a mounting surface. The side wall of the circuit device is a wall that is of the integrated circuit die and that is adjacent to the mounting surface. In step 704, a thermal interface material layer is generated. The thermal interface material layer has a first surface facing the circuit device and the packaging layer and a second surface facing the heat sink fin. In step 706, the first surface is thermally coupled to the circuit device and the packaging layer, and the second surface is thermally coupled to the heat sink fin.

In addition, the disposing a packaging layer around a side wall of a circuit device includes: disposing the packaging layer around the side wall by using a plastic film as a material for manufacturing the packaging layer. The plastic film layer has a desirable heat transfer effect, and can rapidly transfer heat generated on the side wall of the circuit device to the thermal interface material layer, thereby improving heat dissipation efficiency of the circuit device.

During specific manufacturing, the thermal interface material layer is generated. The thermal interface material layer has the first surface facing the circuit device and the packaging layer and the second surface facing the heat sink fin. Specifically:

A first alloy layer is generated. A nano-metal particle layer is generated by using nano-metal particles that are coupled to each other and an intermediate mixture. Diameters of the nano-metal particles are not greater than 1 micrometer. For example, the diameters of the nano-metal particles are between 50 nanometers and 200 nanometers. The intermediate mixture includes, but is not limited to, either of the following materials: air or resin. In an embodiment, the nano-metal particles include, but are not limited to, silver. A second alloy layer is generated. The nano-metal particle layer is thermally coupled to the circuit device and the packaging layer by using the first alloy layer. The second alloy layer is thermally coupled to the nano-metal particle layer and the heat sink fin.

In an embodiment, the method further includes: forming a sintered continuous phase structure at a contact portion between the first alloy layer and the nano-metal particle layer, forming sintered continuous phase structures at contact portions between the nano-metal particles, and forming a sintered continuous phase structure at a contact portion between the second alloy layer and the nano-metal particle layer.

In an embodiment, the method may be used for a flip chip ball grid array package structure, but no limitation is set thereto.

In an embodiment, the generating a first alloy layer includes: generating a first adhesive layer and a first co-sintered layer, thermally coupling the first adhesive layer to the circuit device and the packaging layer, coupling the first co-sintered layer to the nano-metal particle layer, and forming a sintered continuous phase structure at a contact portion between the first co-sintered layer and the nano-metal particle layer. The first adhesive layer includes, but is not limited to, any one of the following materials: titanium, chromium, nickel, or nickel/vanadium. The first co-sintered layer includes, but is not limited to, any one of the following materials: silver, gold, or copper. In another embodiment, the generating a first alloy layer further includes: generating a first buffer layer between the first adhesive layer and the first co-sintered layer. The first buffer layer includes, but is not limited to, any one of the following materials: aluminum, copper, nickel, or nickel/vanadium.

In an embodiment, the generating a second alloy layer includes: generating a second adhesive layer and a second co-sintered layer, thermally coupling the second adhesive layer to the heat sink fin, thermally coupling the second co-sintered layer to the nano-metal particle layer, and forming a sintered continuous phase structure at a contact portion between the second co-sintered layer and the nano-metal particle layer. The second adhesive layer includes, but is not limited to, any one of the following materials: titanium, chromium, nickel, or nickel/vanadium. The second co-sintered layer includes, but is not limited to, any one of the following materials: silver, gold, or copper. In another embodiment, the generating a second alloy layer further includes: generating a second buffer layer between the second adhesive layer and the second co-sintered layer. The second buffer layer includes, but is not limited to, any one of the following materials: aluminum, copper, nickel, or nickel/vanadium.

The circuit device may include the integrated circuit die. Thermally coupling the first alloy layer to the circuit device and the packaging layer includes thermally coupling the first alloy layer to a substrate in the integrated circuit die and the packaging layer.

## Claims

1. A semiconductor apparatus, comprising a circuit device and a heat sink fin (105) that are disposed in a laminated manner, and a thermal interface material layer (104) located between the circuit device and the heat sink fin, wherein
a packaging layer (120) is disposed around a side wall of the circuit device, the circuit device comprises an integrated circuit die (103), the integrated circuit die is provided with a pin, one surface that is of the integrated circuit die and on which the pin is disposed is a mounting surface, and the side wall of the circuit device is a wall that is of the integrated circuit die and that is adjacent to the mounting surface; and
the thermal interface material layer has a first surface facing the circuit device and the packaging layer and a second surface facing the heat sink fin, the first surface is thermally coupled to the circuit device and the packaging layer, and the second surface is thermally coupled to the heat sink fin,
the semiconductor apparatus further comprises a substrate (107), the heat sink fin (105) is fastened on the substrate (107) by using an adhesive (106),
**characterized in that** the
integrated circuit die is coupled to the substrate by using a metal bump (102), the metal bump is protected by a bottom filler (101), the packaging layer envelops the side wall of the integrated circuit die and a side wall of the bottom filler.

2. The semiconductor apparatus according to claim 1, wherein the packaging layer is a plastic film layer.

3. The semiconductor apparatus according to claim 1 or 2, wherein the thermal interface material layer comprises:
a first alloy layer (109), thermally coupled to the circuit device and the packaging layer;
a nano-metal particle layer (110), thermally coupled to the first alloy layer, wherein the nano-metal particle layer comprises multiple nano-metal particles that are coupled to each other and an intermediate mixture, and the intermediate mixture is filled between the multiple nano-metal particles; and
a second alloy layer (112), thermally coupled to the nano-metal particle layer and the heat sink fin.

4. The semiconductor apparatus according to claim 3, wherein a sintered continuous phase structure is formed at a contact portion between the first alloy layer and the nano-metal particle layer, sintered continuous phase structures are formed at contact portions between the multiple nano-metal particles, and a sintered continuous phase structure is formed at a contact portion between the second alloy layer and the nano-metal particle layer.

5. The semiconductor apparatus according to any one of claims 1 to 4, used for a flip chip ball grid array package structure.

6. The semiconductor apparatus according to any one of claims 3 to 5, wherein the first alloy layer comprises a first adhesive layer and a first co-sintered layer, the first adhesive layer is thermally coupled to the circuit device and the packaging layer, the first co-sintered layer is coupled to the nano-metal particle layer, and a sintered continuous phase structure is formed at a contact portion between the first co-sintered layer and the nano-metal particle layer.

7. The semiconductor apparatus according to claim 6, wherein the first adhesive layer comprises any one of the following materials: titanium, chromium, nickel, or a nickel-vanadium alloy, and the first co-sintered layer comprises any one of the following materials: silver, gold, or copper.

8. The semiconductor apparatus according to claim 6 or 7, wherein the first alloy layer further comprises a first buffer layer, located between the first adhesive layer and the first co-sintered layer, and the first buffer layer comprises any one of the following materials: aluminum, copper, nickel, or a nickel-vanadium alloy.

9. The semiconductor apparatus according to any one of claims 3 to 8, wherein the second alloy layer comprises a second adhesive layer and a second co-sintered layer, the second adhesive layer is thermally coupled to the heat sink fin, the second co-sintered layer is thermally coupled to the nano-metal particle layer, and a sintered continuous phase structure is formed at a contact portion between the second co-sintered layer and the nano-metal particle layer.

10. The semiconductor apparatus according to claim 8 or 9, wherein the second alloy layer further comprises a second buffer layer, located between the second adhesive layer and the second co-sintered layer, and the second buffer layer comprises any one of the following materials: aluminum, copper, nickel, or a nickel-vanadium alloy.

11. The semiconductor apparatus according to any one of claims 3 to 10, wherein the intermediate mixture comprises either of the following materials: air or resin.

## Patentansprüche

1. Halbleitervorrichtung, umfassend eine Schaltungseinrichtung und eine Kühlkörperrippe (105), die in einer laminierten Weise angeordnet sind, und eine Wärmeleitpasten-Schicht (104), platziert zwischen der Schaltungseinrichtung und der Kühlkörperrippe, wobei
eine Packungsschicht (120) um eine Seitenwand der Schaltungseinrichtung herum angeordnet ist; die Schaltungseinrichtung einen Die (103) mit integriertem Schaltkreis umfasst; der Die mit integriertem Schaltkreis mit einem Pin bereitgestellt ist; eine zu dem Die mit integriertem Schaltkreis gehörende Oberfläche, auf der der Pin angeordnet ist, eine Montagefläche ist; und die Seitenwand der Schaltungseinrichtung eine Wand ist, die zu dem Die mit integriertem Schaltkreis gehört und die an die Montagefläche angrenzt; und
die Wärmeleitpasten-Schicht eine erste Oberfläche aufweist, die zu der Schaltungseinrichtung weist, und die Packungsschicht und eine zweite Oberfläche zu der Kühlkörperrippe weisen; die erste Oberfläche mit der Schaltungseinrichtung und der Packungsschicht thermisch gekoppelt ist und die zweite Oberfläche mit der Kühlkörperrippe thermisch gekoppelt ist;
die Halbleitervorrichtung ferner ein Substrat (107) aufweist; die Kühlkörperrippe (105) unter Verwendung eines Haftmittels (106) an dem Substrat (107) befestigt ist, **dadurch gekennzeichnet, dass** der Die mit integriertem Schaltkreis unter Verwendung eines Metall-Bumps (102) mit dem Substrat gekoppelt ist; der Metall-Bump durch einen "Bottom Filler" (101) geschützt ist; die Packungsschicht die Seitenwand des Dies mit integriertem Schaltkreis und eine Seitenwand des "Bottom Fillers" umhüllt.

2. Halbleitervorrichtung nach Anspruch 1, wobei die Packungsschicht eine Kunststofffilmschicht ist.

3. Halbleitervorrichtung nach Anspruch 1 oder 2, wobei die Wärmeleitpasten-Schicht umfasst:
eine erste, mit der Schaltungseinrichtung und der Packungsschicht thermisch gekoppelte Legierungsschicht (109);
eine mit der ersten Legierungsschicht thermisch gekoppelte Nanometallpartikel-Schicht (110), wobei die Nanometallpartikel-Schicht mehrere Nanometallpartikel umfasst, die miteinander gekoppelt sind, sowie ein Zwischengemisch, wobei das Zwischengemisch zwischen den mehreren Nanometallpartikeln aufgefüllt ist; und
eine zweite, mit der Nanometallpartikel-Schicht und der Kühlkörperrippe thermisch gekoppelte Legierungsschicht (112).

4. Halbleitervorrichtung nach Anspruch 3, wobei eine gesinterte kontinuierliche Phasenstruktur an einem Kontaktabschnitt zwischen der ersten Legierungsschicht und der Nanometallpartikel-Schicht gebildet wird; gesinterte kontinuierliche Phasenstrukturen an Kontaktabschnitten zwischen den mehreren Nanometallpartikeln gebildet werden; und eine gesinterte kontinuierliche Phasenstruktur an einem Kontaktabschnitt zwischen der zweiten Legierungsschicht und der Nanometallpartikel-Schicht gebildet wird.

5. Halbleitervorrichtung nach einem der Ansprüche 1 bis 4, verwendet für eine "Flip Chip Ball Grid Array"-Packungsstruktur.

6. Halbleitervorrichtung nach einem der Ansprüche 3 bis 5, wobei die erste Legierungsschicht eine erste Haftmittelschicht und eine erste co-gesinterte Schicht umfasst; die erste Haftmittelschicht mit der Schaltungseinrichtung und der Packungsschicht thermisch gekoppelt ist; die erste co-gesinterte Schicht mit der Nanometallpartikel-Schicht gekoppelt ist; und eine gesinterte kontinuierliche Phasenstruktur an einem Kontaktabschnitt zwischen der ersten co-gesinterten Schicht und der Nanometallpartikel-Schicht gebildet wird.

7. Halbleitervorrichtung nach Anspruch 6, wobei die erste Haftmittelschicht ein beliebiges der folgenden Materialien umfasst: Titan, Chrom, Nickel oder eine Nickel-Vanadium-Legierung; und die erste co-gesinterte Schicht ein beliebiges der folgenden Materialien umfasst: Silber, Gold oder Kupfer.

8. Halbleitervorrichtung nach Anspruch 6 oder 7, wobei die erste Legierungsschicht ferner eine erste, zwischen der ersten Haftmittelschicht und der ersten co-gesinterten Schicht platzierte Pufferschicht umfasst und die erste Pufferschicht ein beliebiges der folgenden Materialien umfasst: Aluminium, Kupfer, Nickel oder eine Nickel-Vanadium- Legierung.

9. Halbleitervorrichtung nach einem der Ansprüche 3 bis 8, wobei die zweite Legierungsschicht eine zweite Haftmittelschicht und eine zweite co-gesinterte Schicht umfasst; die zweite Haftmittelschicht mit der Kühlkörperrippe thermisch gekoppelt ist; die zweite co-gesinterte Schicht mit der Nanometallpartikel-Schicht thermisch gekoppelt ist; und eine gesinterte kontinuierliche Phasenstruktur an einem Kontaktabschnitt zwischen der zweiten co-gesinterten Schicht und der Nanometallpartikel-Schicht gebildet wird.

10. Halbleitervorrichtung nach Anspruch 8 oder 9, wobei die zweite Legierungsschicht ferner eine zweite, zwischen der zweiten Haftmittelschicht und der zweiten co-gesinterten Schicht platzierte Pufferschicht umfasst und die zweite Pufferschicht ein beliebiges der folgenden Materialien umfasst: Aluminium, Kupfer, Nickel oder eine Nickel-V anadium-Legierung.

11. Halbleitervorrichtung nach einem der Ansprüche 3 bis 10, wobei das Zwischengemisch eines der folgenden Materialien umfasst: Luft oder Harz.

## Revendications

1. Appareil à semi-conducteur comprenant un composant de circuit et une ailette de dissipateur thermique (105) qui sont disposés d'une manière stratifiée, et une couche de matériau d'interface thermique (104) située entre le composant de circuit et l'ailette de dissipateur thermique, dans lequel
une couche d'encapsulation (120) est disposée autour d'une paroi latérale du composant de circuit, le composant de circuit comprenant une puce de circuit intégré (103), la puce de circuit intégré étant pourvue d'une broche, une surface appartenant à la puce de circuit intégré et sur laquelle la broche est disposée étant une surface de montage, et la paroi latérale du composant de circuit étant une paroi appartenant à la puce de circuit intégré et qui est adjacente à la surface de montage ; et
la couche de matériau d'interface thermique a une première surface tournée vers le composant de circuit et la couche d'encapsulation et une deuxième surface tournée vers l'ailette de dissipateur thermique, la première surface étant couplée thermiquement au composant de circuit et à la couche d'encapsulation, et la deuxième surface étant couplée thermiquement à l'ailette de dissipateur thermique, l'appareil à semi-conducteur comprenant en outre un substrat (107), l'ailette de dissipateur thermique (105) étant attachée au substrat (107) en utilisant une colle (106),
**caractérisé en ce que** la puce de circuit intégré est couplée au substrat en utilisant une bosse métallique (102), la bosse métallique étant protégée par un produit de remplissage inférieur (101), la couche d'encapsulation enveloppant la paroi latérale de la puce de circuit intégré et une paroi latérale du produit de remplissage inférieur.

2. Appareil à semi-conducteur selon la revendication 1, dans lequel la couche d'encapsulation est une couche de film plastique.

3. Appareil à semi-conducteur selon la revendication 1 ou 2, dans lequel la couche de matériau d'interface thermique comprend :
une première couche d'alliage (109), couplée thermiquement au composant de circuit et à la couche d'encapsulation ;
une couche de particules nano-métalliques (110), couplée thermiquement à la première couche d'alliage, la couche de particules nano-métalliques comprenant des particules nano-métalliques multiples qui sont couplées l'une à l'autre et un mélange intermédiaire, et le mélange intermédiaire remplissant l'espace entre les particules nano-métalliques ; et
une deuxième couche d'alliage (112), couplée thermiquement à la couche de particules nano-métalliques et à l'ailette de dissipateur thermique.

4. Appareil à semi-conducteur selon la revendication 3, dans lequel une structure de phase continue frittée est formée au niveau d'une partie de contact entre la première couche d'alliage et la couche de particules nano-métalliques, des structures de phase continue frittées sont formées au niveau de parties de contact entre les particules nano-métalliques multiples, et une structure de phase continue frittée est formée au niveau d'une partie de contact entre la deuxième couche d'alliage et la couche de particules nano-métalliques.

5. Appareil à semi-conducteur selon l'une quelconque des revendications 1 à 4, utilisé pour une structure de boîtier BGA à puce retournée.

6. Appareil à semi-conducteur selon l'une quelconque des revendications 3 à 5, dans lequel la première couche d'alliage comprend une première couche de colle et une première couche cofrittée, la première couche de colle est couplée thermiquement au composant de circuit et à la couche d'encapsulation, la première couche cofrittée est couplée à la couche de particules nano-métalliques, et une structure de phase continue frittée est formée au niveau d'une partie de contact entre la première couche cofrittée et la couche de particules nano-métalliques.

7. Appareil à semi-conducteur selon la revendication 6, dans lequel la première couche de colle comprend un quelconque des matériaux suivants : titane, chrome, nickel, alliage de nickel-vanadium, et la première couche cofrittée comprend un quelconque des matériaux suivants : argent, or ou cuivre.

8. Appareil à semi-conducteur selon la revendication 6 ou 7, dans lequel la première couche d'alliage comprend en outre une première couche tampon, située entre la première couche de colle et la première couche cofrittée, et la première couche tampon comprend un quelconque des matériaux suivants : aluminium, cuivre, nickel ou un alliage de nickel-vanadium.

9. Appareil à semi-conducteur selon l'une quelconque des revendications 3 à 8, dans lequel la deuxième couche d'alliage comprend une deuxième couche de colle et une deuxième couche cofrittée, la deuxième couche de colle est couplée thermiquement à l'ailette de dissipateur thermique, la deuxième couche cofrittée est couplée thermiquement à la couche de particules nano-métalliques, et une structure de phase continue frittée est formée au niveau d'une partie de contact entre la deuxième couche cofrittée et la couche de particules nano-métalliques.

10. Appareil à semi-conducteur selon la revendication 8 ou 9, dans lequel la deuxième couche d'alliage comprend en outre une deuxième couche tampon, située entre la deuxième couche de colle et la deuxième couche cofrittée, et la deuxième couche tampon comprend un quelconque des matériaux suivants : aluminium, cuivre, nickel ou un alliage de nickel-vanadium.

11. Appareil à semi-conducteur selon l'une quelconque des revendications 3 à 10, dans lequel le mélange intermédiaire comprend l'un ou l'autre des matériaux suivants : air ou résine.
